# EUROPÄISCHE PATENTSCHRIFT

(11) **EP 4 710 123 B1**
(45) Veröffentlichungstag und Bekanntmachung des Hinweises auf die Patenterteilung: **02.09.2026**
(21) Anmeldenummer: 24790258.8
(22) Anmeldetag: 20.09.2024
(51) Int. Cl.: G01R 31/389, G01R 31/392

(54) **VERFAHREN, VORRICHTUNG UND SYSTEM ZUR KLASSIFIZIERUNG VON BATTERIEZELLEN EINES BATTERIEPACKS HINSICHTLICH IHRER ZELLGESUNDHEIT**
METHOD, DEVICE AND SYSTEM FOR CLASSIFYING BATTERY CELLS OF A BATTERY PACK WITH REGARD TO THEIR CELL HEALTH
PROCÉDÉ, DISPOSITIF ET SYSTÈME DE CLASSIFICATION D'ÉLÉMENTS DE BATTERIE D'UN BLOC-BATTERIE EN FONCTION DE LEUR ÉTAT DE SANTÉ

(30) Priorität: 21.09.2023 AT 507692023
(43) Veröffentlichungstag der Anmeldung: 18.03.2026
(73) Patentinhaber: AVL List GmbH, 8020 Graz (AT)
(72) Erfinder: EHM, Simon, 2253 Weikendorf (AT); AKYOL, Selçuk, 8020 Graz (AT); PALLEWAR, Pankaj Ganeshrao, 8020 Graz (AT); SIVARAMAN, Thyagesh, 8054 Seiersberg-Pirka (AT)
(86) Internationale Anmeldenummer: PCT/AT2024/060369
(87) Internationale Veröffentlichungsnummer: WO 2025/059706

(56) Entgegenhaltungen:
- CN-A- 105 699 774
- DE-A1- 102019 110 349

## Beschreibung

Die vorliegende Erfindung betrifft ein Verfahren und eine Vorrichtung zur Klassifizierung von Batteriezellen eines Batteriepacks hinsichtlich ihrer Zellgesundheit. Die Erfindung betrifft ferner ein Computerprogrammprodukt zur computerbasierten Ausführung des erfindungsgemäßen Verfahrens sowie ein Batteriesystem mit der erfindungsgemäßen Vorrichtung.

Die Sicherheit von Batterien bei deren Einsatz ist von hoher Bedeutung, um diese für vielfältige Anwendungen nutzbar zu machen. So werden beispielsweise Batterien mit hoher Speicherfähigkeit im Zusammenhang mit Elektrofahrzeugen und Heim- oder Industrie-Photovoltaikanlagen eingesetzt. Oftmals werden Lithium-Ionen-Batterien aufgrund ihrer, im Vergleich zu anderen Batterietypen, relativ hohen Energiedichte verwendet. Um die Energiedichte weiter zu steigern, können Hochspannungsbatterien mit einer Betriebsspannung von wenigstens 60 V Gleichspannung eingesetzt werden.

Mit einer Erhöhung der Energiedichte erhöht sich jedoch auch das Risikopotential, das von derartigen Energiespeichern ausgehen kann. Besonders problematisch ist hierbei, wenn es bei Batterien zu einem Durchbrennen oder thermischen Durchgehen kommt, was auch als "Thermal Runaway" bezeichnet wird.

Im Speziellen beschreibt Thermal Runaway einen sich selbstverstärkenden Wärme produzierenden Prozess. So wird der Prozess durch eine Temperaturerhöhung beschleunigt, wodurch wiederum Wärme freigesetzt wird, die die Temperatur weiter erhöht und somit weiter beschleunigend auf den Prozess wirkt. Derart kann es zu einer Überhitzung von Batterien kommen, die zum Brand und/oder gar zur Explosion der betroffenen Batterie führen kann. Ein Löschen des Batteriebrands oder ein Unterbrechen der Prozesskette ist in solchen Fällen oftmals kaum oder nicht möglich.

Thermal Runaway kann bei Batterien und insbesondere bei Lithium-Ionen-Batterien aufgrund lokaler Temperaturüberhöhungen oder aufgrund eines internen Kurzschlusses der Elektroden auftreten. Bei einem solchen Kurzschluss heizt der resultierende Kurzschlussstrom die Umgebung um die lokale Verbindungsstelle zwischen den Elektroden auf, so dass der Heizprozess sich lokal ausweiten kann und zusätzlich gespeicherte Energie freigesetzt wird.

Die Ursachen für einen internen Kurzschluss können verschiedene sein. So können Verunreinigungen des Separators zwischen den Elektroden, wie eingeschlossene Fremdpartikel, oder eine mechanische Beschädigung des Separators zu einem Kurzschluss führen. Daneben kann es zu einem Kurzschluss jedoch auch bei normalem Gebrauch kommen. So kann es beim wiederholten Aufladen einer Batterie zu einer sog. Dendritenbildung an einer Elektrode der Batterie kommen. Die Dendritenbildung kann zu einem Kurzschluss führen, wenn der Separator von dem gebildeten Dendrit durchstochen wird. Generell wird ein Abscheiden von Substanzen an den Elektroden wie bei der Dendritenbildung mit Fortschreiten der Lade- und Entladezyklen sowie mit zunehmender Batteriealterung begünstigt.

Aus dem Stand der Technik ist es bekannt, Problemen, die sich aus Thermal Runaway ergeben, mittels einer intensiven Überwachung der Batterietemperatur zu begegnen. Ein Nachteil dieser Lösungen ist, dass ein engmaschiges Netz von Temperatursensoren zur Überwachung der Temperaturen einzelner Batteriezellen erforderlich ist. Dieser Umstand ergibt sich auch daraus, dass aufgrund der hohen thermischen Isolierung zwischen einzelnen Batteriezellen lokale Hitzepunkte oftmals unerkannt bleiben, wenn nur wenige oder beispielsweise ein einzelner zentralisierter Temperatursensor eingesetzt wird. Ein engmaschiges Netz aus Temperatursensoren ist jedoch mit einem hohen konstruktiven und kostenmäßigen Aufwand verbunden. Ein weiterer Nachteil ist, dass die Gefahr von Thermal Runaway erst zu einem Zeitpunkt erkannt wird, zu dem Thermal Runaway nicht mehr abgewendet werden kann.

Andere aus dem Stand der Technik, wie beispielsweise die Dokumente DE 10 2019 110349 A1 und CN 105 699 744 A, bekannte Lösungen beschreiben eine Detektion eines Kurzschlusses in einer Batteriezelle, indem der Innenwiderstand einer Batteriezelle ermittelt und mit einem herstellungsspezifischen Bezugswert für den Innenwiderstand verglichen wird. Ein Nachteil derartiger Lösungen ist, dass der Innenwiderstand aufgrund der vielen auftretenden Einflussfaktoren oftmals nur sehr ungenau abgeschätzt werden kann. Entsprechend ist es nicht möglich, eine kritische Veränderung des Innenwiderstands mit hinreichender Genauigkeit und Schnelligkeit festzustellen. Als Konsequenz ist es mit diesen Lösungen ebenfalls nicht möglich, die Gefahr von Thermal Runaway bereits zu einem Zeitpunkt zu erkennen, an dem ein Thermal Runaway noch abgewendet werden könnte.

Es ist daher Aufgabe der vorliegenden Erfindung, die voranstehend beschriebenen Nachteile zumindest teilweise zu beheben. Insbesondere ist es Aufgabe der vorliegenden Erfindung, ein Verfahren und eine Vorrichtung bereitzustellen, welche eine frühzeitige und zuverlässige Erkennung problematischer Veränderungen im Inneren der Batterie ermöglichen. Insbesondere sind solche Veränderungen frühzeitig zu erkennen, die das Potential besitzen, zu einem Thermal Runaway zu führen.

Die voranstehende Aufgabe wird gelöst durch ein Verfahren mit den Merkmalen des Anspruchs 1, ein Computerprogrammprodukt mit den Merkmalen des Anspruchs 9, eine Vorrichtung mit den Merkmalen des Anspruchs 10 sowie ein Batteriesystem mit den Merkmalen des Anspruchs 11.

Weitere Vorteile und Merkmale der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogrammprodukt, der erfindungsgemäßen Vorrichtung sowie dem erfindungsgemäßen Batteriesystem und jeweils umgekehrt, sodass bezüglich der Offenbarung zu den einzelnen Erfindungsaspekten stets wechselseitig Bezug genommen wird beziehungsweise stets wechselseitig Bezug genommen werden kann.

Ein Aspekt der vorliegenden Erfindung betrifft ein Verfahren zur Klassifizierung von Batteriezellen eines Batteriepacks hinsichtlich ihrer Zellgesundheit gemäß Anspruch 1.

Mit anderen Worten wird von der Erfindung ein Verfahren bereitgestellt, mittels dessen Batteriezellen eines Batteriepacks mit Bezug auf deren Zellgesundheit klassifiziert werden.

Im Rahmen der Erfindung kann dabei unter einer Batteriezelle insbesondere die kleinste Einheit einer Batterie zur elektrochemischen Stromproduktion verstanden werden. Die Batteriezelle kann bevorzugt wenigstens zwei Elektroden, einen Elektrolyt, einen Separator und ein Gehäuse aufweisen.

Unter einem Batteriepack kann bevorzugt eine Vielzahl von zusammengeschalteten Batteriezellen verstanden werden. Hierbei sind eine Reihenschaltung und eine Parallelschaltung vorstellbar. Eine Gruppe von zusammengeschalteten Batteriezellen kann in einem Batteriemodul angeordnet sein. Das Batteriepack kann ein oder mehrere der Batteriemodule aufweisen. Das Batteriepack und/oder die Batteriemodule können jeweils von einem Batterie-Management-System (BMS) kontrolliert werden.

Unter Zellgesundheit einer Batteriezelle kann im Rahmen der Erfindung bevorzugt die physische Verfassung einer Batteriezelle verstanden werden. Insbesondere die Verfassung, die einen ordnungsgemäßen Ablauf vorgesehener stromproduzierender elektrochemischer Prozesse in der Batterie ermöglicht, kann von der Zellgesundheit beschrieben werden. So kann durch die Zellgesundheit eine aktuelle Funktions- und Leistungsfähigkeit der Batteriezelle ausgedrückt werden. Bestimmt werden kann die Zellgesundheit beispielsweise anhand des Zustands wesentlicher Elemente der Batteriezelle, wie Elektroden oder Separator, und/oder anhand des Zustands der in der Batteriezelle eingesetzten chemischen Komponenten, wie Katalysatoren oder Elektrolyt. Bevorzugt kann die Zellgesundheit auch anhand von einem oder mehreren Zellparametern bestimmt werden, beispielsweise dem Innenwiderstand der Batteriezelle, der Zellenspannung, dem Zellenstrom, der Zellentemperatur, dem Ladezustand (SOC), von einer oder mehreren Konzentrationen der im Inneren der Batteriezelle auftretenden Substanzen, und/oder State of Health (SoH). Eine Batteriezelle mit schlechter Zellgesundheit kann ein anormales Verhalten, d.h. ein von der Erwartung abweichendes Verhalten wenigstens eines Zellparameters aufweisen.

In dem Verfahren wird für jede der zu klassifizierenden Batteriezellen eine Zellenspannung und ein dazu korrespondierender elektrischer Strom erfasst.

Im Rahmen der Erfindung ist es dabei vorstellbar, dass alle Batteriezellen des Batteriepacks klassifiziert werden oder auch nur einzelne Batteriezellen, wobei wenigstens zwei Batteriezellen zu klassifizieren sind. Unter einem Erfassen kann im Rahmen der Erfindung insbesondere ein Bereitstellen oder Abgreifen von Messdaten verstanden werden. Der elektrische Strom kann bevorzugt für jede Batteriezelle separat oder für alle Batteriezellen gemeinsam erfasst werden. Dies kann beispielsweise davon abhängen, wie die Batteriezellen untereinander miteinander elektrisch verbunden sind, also ob sie beispielsweise in Reihe oder parallel geschaltet sind. Die Zellenspannung und der Strom werden bevorzugt zeitgleich erfasst.

In dem Verfahren wird der elektrische Innenwiderstand jeder der zu klassifizierenden Batteriezellen zu der erfassten Zellenspannung und dem erfassten Strom ermittelt.

Im Rahmen der Erfindung kann Ermitteln bevorzugt als Berechnen, Approximieren und/oder Schätzen verstanden werden. Der elektrische Innenwiderstand einer Batteriezelle ist der Widerstand der Batteriezelle gegen einen Stromfluss.

In dem Verfahren wird ferner jede der zu klassifizierenden Batteriezellen auf Basis der ermittelten Innenwiderstände als gesund klassifiziert, wenn eine Abweichung ΔiR des jeweiligen Innenwiderstands von einem Innenwiderstand-Referenzwert innerhalb eines Normalbereichs liegt. Der Innenwiderstand-Referenzwert ist dabei zeitlich veränderlich vorgesehen. Die Klassifizierung der Batteriezellen wird als Klassifizierungsergebnis ausgegeben.

Die erfindungsgemäße Konfiguration des Verfahrens erlaubt es, die Zellgesundheit eines Batteriepacks auf Batteriezellen-Ebene anhand von Veränderungen des Innenwiderstands von Batteriezellen über die Zeit zu bewerten und zu kategorisieren. Die Erfindung macht sich hierbei geschickt den Zusammenhang zu Nutze, dass Veränderungen des Batteriezellen-Innenwiderstands unmittelbar mit Veränderungen deren Zellgesundheit verwoben sind. Auch zeigt der Innenwiderstand eine starke Abhängigkeit von der jeweils vorliegenden Zellentemperatur. Die zeitliche Variabilität des Innenwiderstand-Referenzwertes, welcher für die Berechnung der Veränderung herangezogen wird, erlaubt es, Umgebungsbedingungen, Betriebsbedingungen, oder Alterungs- und Veränderungsprozesse bei der Berechnung der Änderung miteinzubeziehen und damit beim Kategorisieren zu berücksichtigen. Folglich kann in dem Verfahren eine Entwicklung der Zellgesundheit zu einem sich stark verschlechternden Zustand der Batteriezelle, bei dem Thermal Runaway auftritt, genau, frühzeitig und zellenspezifisch erfasst und detektiert werden. Betroffene Batteriezellen können durch eine entsprechende Kategorisierung markiert werden. Entsprechend kategorisierte Batteriezellen können so beispielsweise von dem BMS deaktiviert werden, so dass ein Eintreten von Thermal Runaway in diesen Batteriezellen verhindert werden kann, alternativ dazu können hier auch benachbarte Batteriezellen oder das gesamte Batteriepack deaktiviert werden. Anders als im Stand der Technik kann somit auf Temperatursensoren für jede einzelne Batteriezelle verzichtet werden.

Gemäß einer bevorzugten Ausgestaltung kann das Verfahren einen Schritt des Ermittelns aufweisen, indem der Innenwiderstand-Referenzwert ermittelt wird. Der Referenzwert-Ermittlungsschritt kann bevorzugt vor dem Schritt des Kategorisierens durchgeführt werden.

Bevorzugt kann der Innenwiderstand-Referenzwert von einem früheren, bevorzugt dem letzten, Klassifizierungsergebnis abhängen. Ferner bevorzugt kann der Innenwiderstand-Referenzwert ein Mittelwert aus den ermittelten Innenwiderständen von zuletzt als gesund klassifizierten Batteriezellen sein. Der Mittelwert kann dabei beispielsweise als ein arithmetischer, geometrischer oder gewichteter Mittelwert gebildet werden.

Mit diesen Konfigurationen können zuletzt ermittelte Klassifizierungsergebnisse in aktuelle Klassifizierungen der Batteriezellen miteinbezogen werden. Somit werden bei der Ermittlung des Innenwiderstand-Referenzwertes nur die Batteriezellen berücksichtigt, für die zuletzt ein ordnungsgemäßer Betrieb möglich zu sein scheint. Entsprechend werden auch Veränderungen des Innenwiderstands nur bezüglich eines Referenzwertes ermittelt, welcher eine ordnungsgemäß funktionierende Batteriezelle beschreiben kann. Als besonderer Vorteil der erfindungsgemäßen Differenzbildung mit dem gemittelten Innenwiderstand-Referenzwert stellt sich ein, dass die Abweichung ΔiR vornehmlich Änderungen widerspiegelt, die auf Verfassungsänderungen der einzelnen Batteriezelle zurückzuführen sind. Fluktuationen der Innenwiderstände, die auf Einflussfaktoren zurückzuführen sind, von denen alle Batteriezellen gleichermaßen betroffen sind, werden durch die Differenzbildung hingegen eliminiert. Dies können Messfehler, erwartbare Temperaturschwankungs- oder Zellenalterungseffekte sein.

Der Innenwiderstand-Referenzwert kann für jede der Batteriezellen identisch oder unterschiedlich sein.

Somit können beispielsweise auch Batteriepack Konfigurationen berücksichtigt werden, die verschiedene Batterietypen verwenden oder anderweitig konfiguriert sind.

Alternativ oder zusätzlich kann der Innenwiderstand-Referenzwert initial ein Mittelwert aus den ermittelten Innenwiderständen jeder der Batteriezellen sein.

Alternativ kann der Innenwiderstand-Referenzwert initial ein bei der Batteriepackherstellung bestimmter Innenwiderstand sein. Bevorzugt kann der Innenwiderstand-Referenzwert auch ein Mittelwert aus den bei der Batteriepackherstellung bestimmten Innenwiderständen der Batteriezellen sein.

Somit kann ein Referenzwert bereitgestellt werden, der bei Inbetriebnahme des Batteriepacks verwendet werden kann.

Alternativ oder zusätzlich kann die Abweichung ΔiR eine Abweichung des Innenwiderstands der jeweiligen Batteriezelle von dem Innenwiderstand-Referenzwert in Relation zu dem Innenwiderstand-Referenzwert sein. Bevorzugt kann dabei die Abweichung ΔiR eine prozentuale Abweichung sein. Ferner bevorzugt kann die Abweichung ΔiR durch Division eines Differenzergebnisses, welches die Differenz aus dem Innenwiderstand der jeweiligen Batteriezelle und dem Innenwiderstand-Referenzwert ist, durch den Innenwiderstand-Referenzwert ermittelt werden.

Anhand der Relativierung der Abweichung ΔiR zu dem Innenwiderstand-Referenzwert werden ungewöhnliche Abweichungen von einem Normalzustand besonders deutlich und schnell erkennbar. Derartige "Normierungen" haben ferner den Vorteil, dass sie einheitenlose Größen bilden und zumeist in einem Bereich von - 1 bis +1 liegen. Entsprechend ist es möglich, kritische Abweichungsbereiche einmalig festzulegen und nicht variabel anpassen zu müssen. Dabei ist ferner von Vorteil, dass der Innenwiderstand-Referenzwert zeitlich variabel ist, so dass sich die Abweichung ΔiR zeitangepasst verändern kann. Entsprechend kann das Verfahren auf eine einmalige Kalibrierung zurückgreifen, die über die Betriebsdauer verwendet werden kann. Die vorgenannten Vorteile können insbesondere dadurch weiter gesteigert werden, indem auf den Innenwiderstand-Referenzwert als Mittelwert aus den Innenwiderständen von zuletzt als gesund klassifizierten Batteriezellen zurückgegriffen wird.

Das Verfahren weist ferner ein Ermitteln eines Ist-Betriebsmodus des Batteriepacks wenigstens aus einem Verlauf des für die Batteriezellen erfassten Stroms auf. Bevorzugt kann dieser Schritt des Ermittelns ferner aus einem Verlauf wenigstens einer erfassten Zellenspannung erfolgen. Der Ist-Betriebsmodus weist dabei einen Konstant-Betriebsmodus für einen Abschnitt des Verlaufs des Stroms auf, welcher einen konstanten oder im Wesentlich konstanten Verlauf und bevorzugt keiner Nullstelle aufweist. Der Konstant-Betriebsmodus kann beispielsweise ein Batterie-Ladebetriebsmodus und/oder ein Batterie-Entladebetriebsmodus sein. Der Ist-Betriebsmodus weist einen Dynamik-Betriebsmodus für einen Abschnitt des Verlaufs des Stroms auf, welcher wenigstens einen Strompuls und bevorzugt wenigstens eine Nullstelle aufweist. Der Dynamik-Betriebsmodus kann beispielsweise ein Fahrbetriebsmodus sein. Alternativ oder zusätzlich kann der Ist-Betriebsmodus einen Leerlauf-Betriebsmodus für einen Abschnitt des Verlaufs des Stroms aufweisen, welcher keinen oder nahezu keinen Stromfluss aufweist. Somit wird es möglich, verschiedene Betriebsarten des Batteriepacks zu ermitteln und diese Ermittlungsergebnisse in die Kategorisierung miteinzubeziehen. Weiters wird der Innenwiderstand der Batteriezellen in Abhängigkeit von dem ermittelten Ist-Betriebsmodus des Batteriepacks ermittelt. So kann im Konstant-Betriebsmodus der Innenwiderstand aus einem Potentialunterschied zwischen einer Ist-Leerlaufspannung der Batteriezelle und der erfassten Zellenspannung, und aus dem erfassten Strom ermittelt werden, wobei bevorzugt die Ist-Leerlaufspannung zu einem erfassten Ladezustand der Batteriezelle ermittelt wird. Im Dynamik-Betriebsmodus wird der Innenwiderstand hingegen aus einer Differenz der erfassten Zellenspannung zu Beginn und am Ende eines Strompulses, und aus dem am Ende eines Strompulses erfassten Strom ermittelt werden.

Damit wird es möglich, je nach Betriebsmodus den Innenwiderstand der Batteriezellen zu ermitteln. Dies ermöglicht es, die Zellphysik, die für den jeweiligen Betriebsmodus vorliegt, zu berücksichtigen. Entsprechend kann eine genaue und aussagekräftige Ermittlung des Innenwiderstands erfolgen.

Gemäß einer bevorzugten Ausgestaltung kann für jede der Batteriezellen der Strom an einer Elektrode des Batteriepacks oder an einer Elektrode der jeweiligen Batteriezelle erfasst werden.

Der Strom, welcher mit der jeweiligen Zellenspannung korrespondiert, kann somit der Batteriepack-Strom oder ein zu der Batteriezelle zugehöriger Zellenstrom sein.

Jede der Batteriezellen wird auf Basis der ermittelten Innenwiderstände als anormal klassifiziert werden, wenn die Abweichung ΔiR außerhalb des Normalbereichs liegt. Insbesondere kann jede der als anormal klassifizierten Batteriezellen als stark-alternd klassifiziert werden, wenn die Abweichung ΔiR größer als eine Alterungsabweichungsgrenze ist. Alternativ oder zusätzlich kann jede der als anormal klassifizierten Batteriezellen als Kurzschluß-gefährdet klassifiziert werden, wenn die Abweichung ΔiR negativ und kleiner als eine Kurzschlussabweichungsgrenze ist und bevorzugt die Abweichung ΔiR eine Änderungsrate größer als ein Änderungsratengrenzwert aufweist. Alternativ oder zusätzlich kann jede der als anormal klassifizierten Batteriezellen als überhitzt klassifiziert werden, wenn die Abweichung ΔiR negativ und kleiner als eine Temperaturabweichungsgrenze ist und wenigstens eine erfasste Temperatur des Batteriepacks eine Temperaturgrenze passiert.

Dies ermöglicht es, Ursachen für eine Verschlechterung der Zellgesundheit zu identifizieren und entsprechend der Ursache zu reagieren. Die Erfindung macht sich dabei geschickt zu Nutze, dass beispielsweise mit der Alterung einer Batteriezelle der Innenwiderstand ansteigt, oder bei Kurzschluss abnimmt. Die starke Temperaturabhängigkeit des Innenwiderstandes erlaubt es, eine Risikoabwägung vorzunehmen und zu entscheiden, ob der aktuelle Zyklus oder auch weitere Zyklen der Batteriezelle zu Thermal Runaway führen.

Gemäß einer bevorzugten Ausgestaltung kann der Normalbereich eine Obergrenze und eine Untergrenze aufweisen, welche bevorzugt in Abhängigkeit von der Baustruktur der Batteriezelle definiert sind. Bevorzugt können Werte aus dem Normalbereich absolut gesehen kleiner sein als die Alterungsabweichungsgrenze, die Kurzschlussabweichungsgrenze oder die Temperaturabweichungsgrenze. Beispielsweise kann der Normalbereich ein symmetrischer Bereich sein, wie -5% bis 5% Abweichung von dem Innenwiderstand-Referenzwert.

Somit kann eine Erkennung als nicht-gesunde Batteriezelle vorteilhaft erfolgen. Gemäß einer ferner bevorzugten Ausgestaltung kann das Verfahren einen Schritt des Kalibrierens aufweisen, indem wenigstens der Normalbereich festgelegt wird. Bevorzugt können auch andere der vorgenannten Grenzen, wie die Alterungsabweichungsgrenze, die Kurzschlussabweichungsgrenze, der Änderungsratengrenzwert, die Temperaturabweichungsgrenze, oder die Temperaturgrenze, in einem Kalibrierungsschritt bestimmt werden.

Somit können die Grenzbereiche am Batteriepack unmittelbar ermittelt werden, so dass die Genauigkeit des Verfahrens gesteigert werden kann.

Gemäß einer bevorzugten Ausgestaltung kann das erfindungsgemäße Verfahren einen Schritt des Validierens aufweisen, indem die beim Kalibrieren bestimmten Bereiche mittels Vergleichsdaten überprüft werden. Die Vergleichsdaten können dabei beispielsweise aus einer Simulation oder einer Messung stammen.

Somit können die Grenzbereiche am Batteriepack unmittelbar überprüft werden, so dass die Genauigkeit des Verfahrens gesteigert werden kann.

Der Schritt des Ausgebens umfasst die Ausgabe von Informationen zu dem Klassifikationsergebnis, insbesondere zu Anzahl und Identifikationsnummer der als gesund klassifizierten Batteriezellen und zu Anzahl sämtlicher der Batteriezellen, einer Warnung, und/oder eines Kontrollsignals zur Übermittlung an eine Steuervorrichtung des Batteriepacks, um die Batteriezellen des Batteriepacks in Abhängigkeit von dem jeweiligen Klassifikationsergebnis wahlweise zu aktivieren oder deaktivieren. Bevorzugt wird an eine Ausgabevorrichtung für einen Benutzer ausgegeben.

Bevorzugt kann das Verfahren ferner einen Schritt des Analysierens des Klassifikationsergebnis aufweisen. Dabei kann insbesondere ermittelt werden, ob die Anzahl von als gesund klassifizierten Batteriezellen eine Mindestanzahl überschreitet.

Bevorzugt kann eine Warnung ausgegeben werden, wenn eine oder mehrere Batteriezellen wiederholt nicht als gesund klassifiziert werden. Alternativ oder zusätzlich kann eine Warnung ausgegeben werden, wenn eine zu hohe Anzahl von Batteriezellen nicht als gesund klassifiziert wird. Bevorzugt können notwendige Grenzwerte zur Bewertung dieser Vorfälle durch Kalibrieren gefunden und/oder vom Benutzer festgelegt werden.

Derart kann eine Warnung und Rückkopplung mit einem Benutzer erfolgen. Gemäß einer bevorzugten Ausgestaltung kann das Verfahren zur Klassifizierung der Batteriezellen während des laufenden Betriebs des Batteriepacks vorgesehen sein. Bei dem Batteriepack kann es sich um ein Lithium-Ionen Batteriepack handeln. Insbesondere kann das Batteriepack ein Hochspannungsbatteriepack für ein Elektrofahrzeug sein. Bevorzugt kann das Batteriepack wenigstens 100 oder 200 Batteriezellen aufweisen, welche bevorzugt in dem Batteriepack in Reihe geschaltet sind. Alternativ oder zusätzlich kann das Batteriepack einen Spannungssensor für jede der zu klassifizierenden Batteriezellen aufweisen, um die jeweilige Zellenspannung zu erfassen. Das Verfahren kann beispielsweise ein Diagnoseverfahren für das Batteriepack sein. Das Verfahren kann ferner zur Vorhersage von Thermal Runaway vorgesehen und/oder ausgestaltet sein.

Das erfindungsgemäße Verfahren kann in Kombination mit den oben genannten Konfigurationen vorteilhaft ausgeführt werden, ist auf diese jedoch nicht beschränkt. Ein weiterer Aspekt der Erfindung betrifft ein Computerprogrammprodukt gemäß Anspruch 9.

Ein weiterer Aspekt der Erfindung betrifft eine Vorrichtung zur Klassifizierung von Batteriezellen eines Batteriepacks hinsichtlich ihrer Zellgesundheit gemäß Anspruch 10.

Die Vorrichtung ist insbesondere zur Ausführung des erfindungsgemäßen Verfahrens fähig und/oder eingerichtet.

Die Vorrichtung weist ein Betriebsmodus-Ermittlungsmodul zum Ermitteln eines Ist-Betriebsmodus des Batteriepacks auf, welches wenigstens einen Verlauf des für die Batteriezellen erfassten Stroms und bevorzugt ferner einen Verlauf wenigstens einer erfassten Zellenspannung verwendet. Bevorzugt kann die Vorrichtung eine Diagnosevorrichtung oder eine Vorhersagevorrichtung für Thermal Runaway sein.

Ein weiterer Aspekt der Erfindung betrifft ein Batteriesystem gemäß Anspruch 11.

Bevorzugt kann das Batteriesystem eine Ausgabevorrichtung für einen Benutzer zur Ausgabe des Klassifizierungsergebnisses aufweisen.

Mit dem vorgenannten Computerprogrammprodukt, der vorgenannten Vorrichtung und dem vorgenannten Batteriesystem können dieselben technischen Effekte und Vorteile erreicht werden, die bereits für das Kontrollverfahren beschrieben wurden. Daher wird nachfolgend lediglich auf die entsprechenden Ausführungen verwiesen.

In einer bevorzugten Ausgestaltung kann das Batteriesystem wenigstens eine Abschaltvorrichtung mit einem schaltbaren Trennabschnitt zur Unterbrechung des elektrischen Ladungstransports in einer oder mehreren der Batteriezellen aufweisen, wobei die Abschaltvorrichtung mit der Vorrichtung verbunden ist, um die Abschaltvorrichtung in Abhängigkeit des Klassifizierungsergebnisses zu schalten.

Dadurch wird es möglich, Batteriezellen mit schlechter Zellgesundheit gegebenenfalls abschalten zu können und so einen Thermal Runaway zu verhindern.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben werden. Es zeigen schematisch:
- Fig. 1: eine Ausführungsform des erfindungsgemäßen Verfahrens,
- Fig. 2: eine weitere Ausführungsform des erfindungsgemäßen Verfahrens,
- Fig. 3: eine weitere Ausführungsform des erfindungsgemäßen Vorrichtung und des erfindungsgemäßen Batteriesystems,
- Fig. 4: eine weitere Ausführungsform des erfindungsgemäßen Batteriesystems,
- Fig. 5: Beispiele für Spannungs- und Stromverläufe einer Batteriezelle.

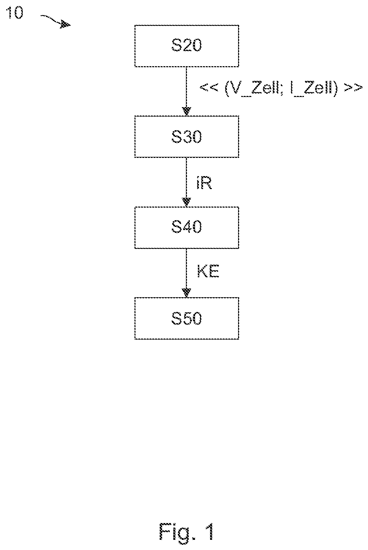

Die Figuren 1 bis 5 zeigen unterschiedliche Aspekte und Ausführungsbeispiele der Erfindung.

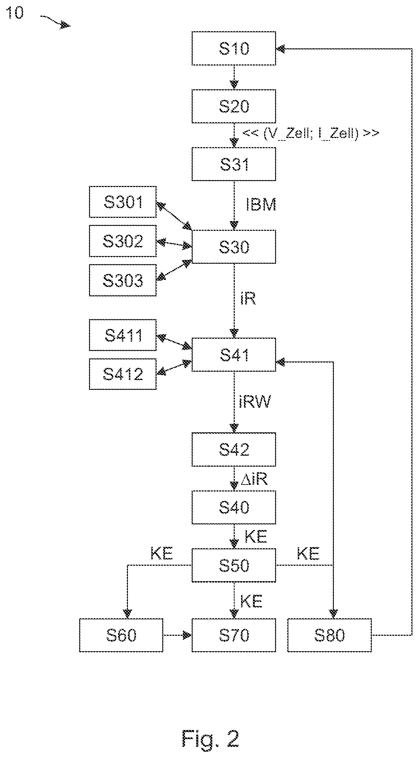

Ein Aspekt der Erfindung betrifft ein Verfahren 10 zur Klassifizierung von Batteriezellen 1100 eines Batteriepacks 1001 hinsichtlich ihrer Zellgesundheit. Die Figuren 1 und 2 zeigen jeweils beispielhaft Ausführungsbeispiele des erfindungsgemäßen Verfahrens 10. Bei den Batteriezellen 1100 kann es sich insbesondere um Lithium-Ionen-Batteriezellen für Elektrofahrzeuge handeln.

Das Verfahren 10 aus Figur 1 weist dabei vier Verfahrensschritte auf. So wird in einem Erfassen-Schritt S20 für jede der zu klassifizierenden Batteriezellen 1100 eine Zellenspannung V_Zell und ein dazu jeweils korrespondierender elektrischer Strom I_Zell erfasst. In Figur 1 ist die Vielzahl der erfassten Wertepaare als Array in Klammern "<<..:>>" dargestellt. Der erfasste Strom I_Zell kann bei einer Reihenschaltung der Batteriezellen 1100 beispielsweise der Batteriepack-Strom sein. Neben der Zellenspannung V_Zell und dem Strom I_Zell können weitere Größen erfasst werden. Beispielsweise kann eine Zelltemperatur und/oder ein Ladezustand (SOC) erfasst werden. Spannungs-, Strom und/oder Temperaturwerte können beispielsweise von einem Batteriemanagementsystem (BMS) oder von eigens vorgesehenen Sensoren erfasst werden. Aus dem jeweiligen Wertepaar von Zellenspannung V_Zell und dem erfassten Strom I_Zell kann in einem Innenwiderstand-Ermittlungsschritt S30 der korrespondierende elektrische Innenwiderstand iR der jeweiligen Batteriezelle 1100 ermittelt werden. In einem Klassifizieren-Schritt S40 wird jede der Batteriezellen 1100 auf Basis der ermittelten Innenwiderstände iR klassifiziert. In dem Klassifizieren-Schritt S40 wird eine Batteriezelle 1100 dann als gesund klassifiziert, wenn eine Abweichung ΔiR des jeweiligen Innenwiderstands iR von einem zeitlich veränderlich vorgesehenen Innenwiderstand-Referenzwert iRW innerhalb eines Normalbereichs liegt. Die Klassifizierung der Batteriezellen 1100 wird in einem Ausgabe-Schritt S50 als ein Klassifizierungsergebnis KE ausgegeben. Das Verfahren 10 kann somit beispielsweise als ein Diagnoseverfahren der Batteriezellen 1100 fungieren.

Figur 2 zeigt ein weiteres Ausführungsbeispiel für das Verfahren 10, welches zusätzlich zu den bereits erläuterten Schritten S20 bis S50 noch weitere bevorzugte Verfahrensschritte aufweist.

So weist das in Figur 2 beispielhaft dargestellte Verfahren 10 einen Kalibrier-Schritt S10 auf, in dem beispielsweise eine Bestimmung und Festlegung der Messgenauigkeit, Messfrequenz, Messfenstergröße, Datenpuffergrößen, SignalFilter und weiterer einzustellender Größen des Verfahrens 10 vorgenommen werden kann. Insbesondere kann beispielsweise eine Ober- und Untergrenze des Normalbereichs in dem Kalibrier-Schritt S10 gefunden werden.

Nach der optionalen Parametrierung in dem Kalibrier-Schritt S10 werden, wie bereits erläutert, in dem Erfassen-Schritt S20 wenigstens die Zellenspannung V_Zell und der dazu korrespondierende Strom I_Zell erfasst.

In einem Betriebsmodus-Ermittlungsschritt S31 kann ein momentan vorliegender Ist-Betriebsmodus IBM des Batteriepacks 1001 oder der jeweiligen Batteriezellen 1100 aus den Verläufen der jeweils erfassten Größen ermittelt werden.

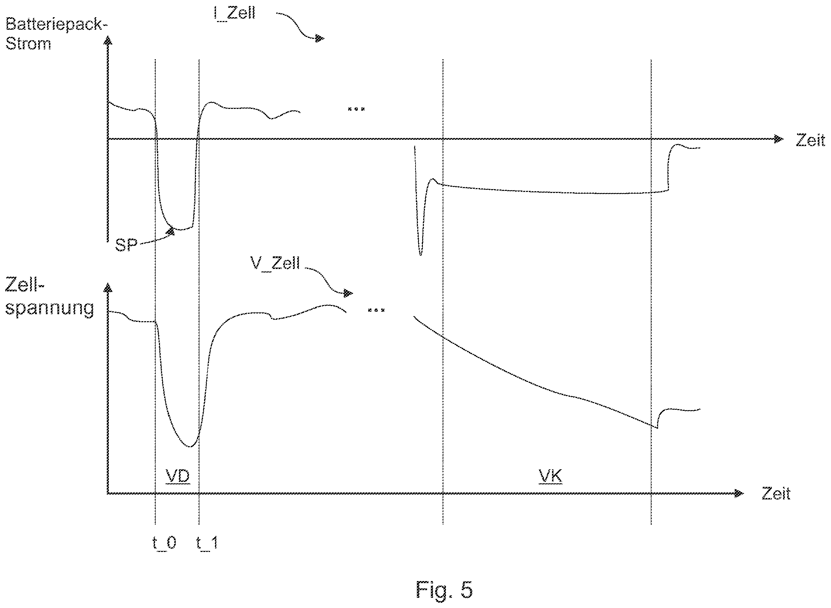

Figur 5 zeigt derartige Verläufe für die Zellenspannung V_Zell und den erfassten Strom I_Zell. Typischerweise finden sich für ein Batteriepack 1001 eines Elektrofahrzeugs wenigstens drei zu unterscheidende Ist-Betriebsmodi IBM. Die Erfindung ist natürlich nicht auf die nachfolgend beschriebenen Ist-Betriebsmodi IBM beschränkt, sondern erläutert diese lediglich beispielhaft. So kann beispielsweise im Entladebetrieb ein Abschnitt VK des Verlaufs des Stroms I_Zell mit einem annähernd konstanten Verlauf und ohne Nullstelle gefunden werden. Entsprechendes findet sich auch für den Aufladebetrieb, so dass auf diese Betriebsarten auch als Konstant-Betriebsmodus Bezug genommen wird. Im regulären Fahrbetrieb zeichnen sich die Verläufe des Stroms I_Zell oftmals durch Abschnitte VD mit wenigstens einem Strompuls SP und bevorzugt wenigstens einer Nullstelle aus. Aufgrund der Dynamik, welche oftmals in solchen Signalverläufen gefunden werden kann, wird auf diese Betriebsart auch als Dynamik-Betriebsmodus Bezug genommen. Daneben findet sich auch ein Leerlauf-Betriebsmodus, in dem Abschnitte des Verlaufs des Stroms I_Zell nahezu keinen Stromfluss aufweisen.

In dem Innenwiderstand-Ermittlungsschritt S30 aus Figur 2 wird der Innenwiderstand iR der jeweiligen Batteriezelle 1100 unter Berücksichtigung des Ist-Betriebsmodus IBM ermittelt. Für den Konstant-Betriebsmodus kann im Schritt S301 der Innenwiderstand iR anhand des Ohmschen-Gesetzes aus einem Potentialunterschied zwischen einer ermittelten Ist-Leerlaufspannung der Batteriezelle 1100 und der erfassten Zellenspannung V_Zell, und aus dem erfassten Strom I_Zell fortlaufend ermittelt werden. Die Ist-Leerlaufspannung kann beispielsweise aus einer Look-Up-Tabelle anhand des Ladezustands SOC ermittelt werden.

Anders verhält sich die Ermittlung des Innenwiderstands iR für den Dynamik-Betriebsmodus. Hierbei ist der Innenwiderstand iR beispielsweise singulär aus den Werten für die Zellenspannung V_Zell und den Strom I_Zell, welche zu Beginn und am Ende eines Strompulses SP vorliegen, zu berechnen. In Figur 5 ist der Beginn des Strompulses SP als Zeitpunkt t_0 und dessen Ende als Zeitpunkt t_1 dargestellt. In dem Schritt S302 wird dies entsprechend umgesetzt. Schritt S303 überspringt die Ermittlung des Innenwiderstands iR für den Leerlauf-Betriebsmodus. Natürlich sind auch andere Implementierungen zur Ermittlung des Innenwiderstands iR vorstellbar.

Ehe in dem Klassifizieren-Schritt S40 eine Klassifizierung der Batteriezellen 1100 vorgenommen wird, kann in einem Referenzwert-Ermittlungsschritt S41 ein Wert für den Innenwiderstand-Referenzwert iRW ermittelt werden. So kann beispielsweise, wenn das Verfahren 10 zum ersten Mal durchlaufen wird, der Innenwiderstand-Referenzwert iRW in einem initialen Referenzwert-Ermittlungsschritt S411 ermittelt werden. Hierbei kann beispielsweise ein Wert, der vom Hersteller als der Innenwiderstand iR der Batteriezellen 1100 angegeben wurde, Verwendung finden. Für weitere Durchläufe des Verfahrens 10 kann alternativ in einem laufenden Referenzwert-Ermittlungsschritt S412 wiederholt der Innenwiderstand-Referenzwert iRW neu bestimmt werden. So kann beispielsweise der Innenwiderstand-Referenzwert iRW von einem früheren, Klassifizierungsergebnis KE abhängen, indem dem Innenwiderstand-Referenzwert iRW der arithmetische Mittelwert aus den Innenwiderständen iR, welche zuletzt als gesunde Batteriezellen 1100 klassifiziert wurden, zugewiesen wird.

In einem Abweichungs-Ermittlungsschritt S42 kann die Abweichung ΔiR ermittelt werden. Bevorzugt kann dabei die Abweichung ΔiR eine relative Abweichung des Innenwiderstands iR der jeweiligen Batteriezelle 1100 von dem Innenwiderstand-Referenzwert iRW in Relation zu dem Innenwiderstand-Referenzwert iRW sein. So kann beispielsweise die Abweichung ΔiR zu einem Zeitpunkt t einer jeder Batteriezelle 1100 durch nachfolgende Formel ermittelt werden: $Δ {{iR}^{t}}_{n} = \frac{{iR}_{n}^{t} - {iRW}^{t}}{{iRW}^{t}}$

Dabei deutet der Index n die Nummerierung der jeweiligen Batteriezelle 1100 an. Insbesondere für den Fall, dass der Innenwiderstand-Referenzwert iRW der arithmetische Mittelwert aus den Innenwiderständen iR von zuletzt, also zu einem Zeitpunkt t-1, als gesund klassifizierten Batteriezellen 1100 gebildet wird, ergibt sich: $Δ {{iR}^{t}}_{n} = \frac{{iR}_{n}^{t} - Mittelwert \left({iR}_{Zelle = gesund}^{t - 1}\right)}{Mittelwert \left({iR}_{Zelle = gesund}^{t - 1}\right)}$

Mittels der Abweichungen ΔiR erfolgt dann die Klassifizierung der Batteriezellen 1100 hinsichtlich ihrer Zellgesundheit in dem Klassifizieren-Schritt S40. Dabei wird die jeweilige Abweichung ΔiR gegenüber einem Normalbereich verglichen. Bevorzugt können dabei auch noch eine weitere Abstufungen und Vergleiche mit anderen Grenzbereichen erfolgen, um die Zellgesundheit noch feiner zu beurteilen oder mögliche Ursachen für die sich ggf. verschlechternde Zellgesundheit zu identifizieren.

Das Ergebnis des Klassifizierens aus Schritt S40 wird in dem Ausgabe-Schritt S50 ausgegeben. Beispielsweise kann eine Information oder Warnung an einen Nutzer erfolgen. Auch kann ein Bereitstellen des Klassifizierungsergebnis KE für einen nachfolgenden Abweichungs-Ermittlungsschritt S42 erfolgen.

Alternativ oder zusätzlich kann ferner ein Diagnose- und/oder Analyse-Schritt S60 durchgeführt werden, um aus dem Klassifizierungsergebnis KE weitere Informationen abzuleiten. Darauf basierend kann beispielsweise ein Kontrollsignal KS in einem Kontroll-Schritt S70 zur Ansteuerung der betroffenen Batteriezellen 1100 erzeugt werden (in Figur 2 nicht dargestellt). Ferner ist es auch vorstellbar, in einem Validieren-Schritt S80 das Klassifizierungsergebnis KE zur Validierung einer initialen Kalibrierung aus dem Kalibrier-Schritt S10 zu überprüfen und gegebenenfalls anzupassen.

Anhand der Figuren 1 und 2 wird ferner deutlich, wie mögliche Implementierungen des Verfahrens 10 als Computerprogrammprodukt gestaltet werden können.

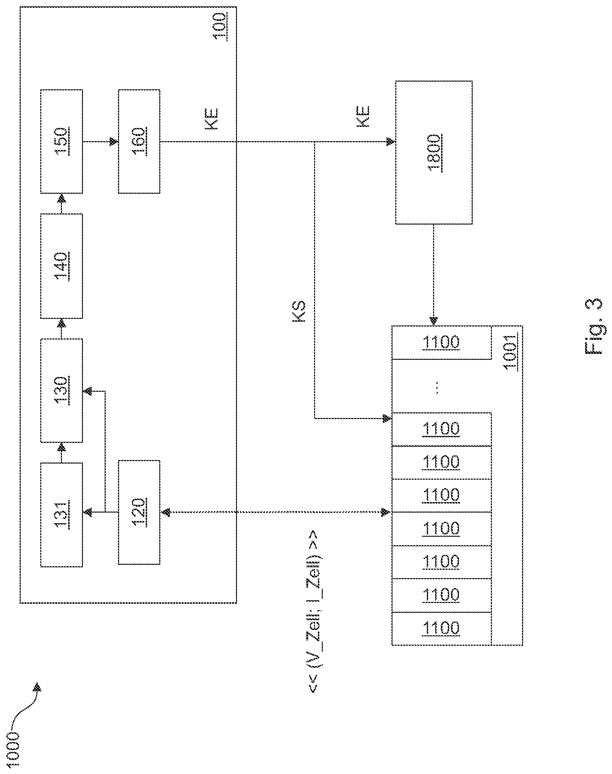

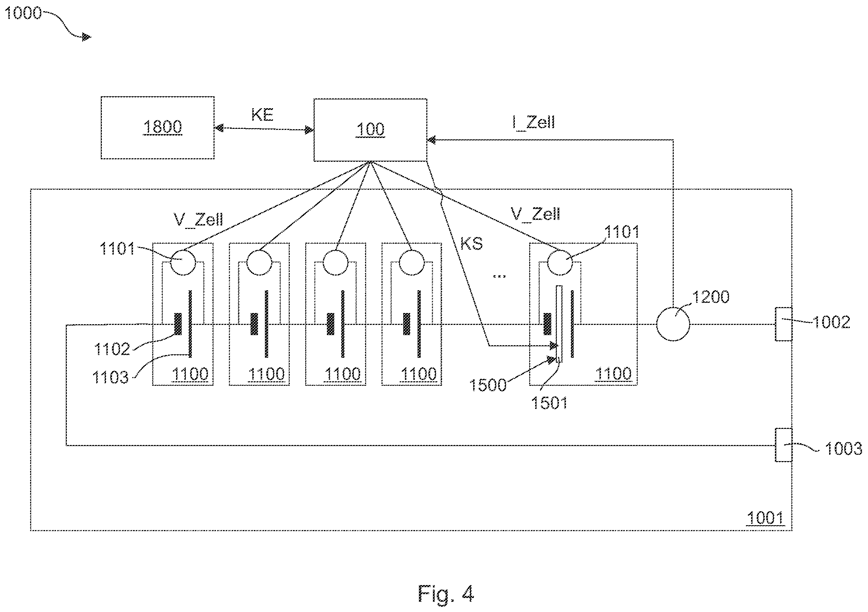

Die Figuren 3 und 4 zeigen jeweils ein Ausführungsbeispiel einer erfindungsgemäßen Vorrichtung 100 zur Klassifizierung von Batteriezellen 1100 des Batteriepacks 1001 hinsichtlich ihrer Zellgesundheit.

Figur 3 zeigt insbesondere einen möglichen Aufbau und Signalfluss der Vorrichtung 100. Die Vorrichtung 100 weist dabei ein Erfassungsmodul 120 zum Erfassen der Zellenspannung V_Zell und des Stroms I_Zell für jede der zu klassifizierenden Batteriezellen 1100 auf. In Figur 3 ist der Signalfluss zwischen dem Batteriepack 1001 und/oder den Batteriezellen 1100 durch eine unterbrochene Linie angedeutet. Die Vorrichtung 100 weist bevorzugt ein Betriebsmodus-Ermittlungsmodul 131 zum Ermitteln des Ist-Betriebsmodus IBM des Batteriepacks 1001 aus einem Verlauf des für die Batteriezellen 1100 erfassten Stroms I_Zell auf. Ferner wird in einem Ermittlungsmodul 130 der elektrische Innenwiderstand iR der jeweiligen Batteriezelle 1100 aus der erfassten Zellenspannung V_Zell und dem erfassten Strom I_Zell ermittelt. Ein Klassifizierungsmodul 140 zum Klassifizieren jeder der Batteriezellen 1100 auf Basis der ermittelten Innenwiderstände iR ist vorgesehen, welches dazu eingerichtet ist, die Batteriezellen 1100 als gesund zu klassifizieren, wenn die Abweichung ΔiR des jeweiligen Innenwiderstands iR von dem Innenwiderstand-Referenzwert iRW innerhalb eines Normalbereichs liegt. Dabei ist der Innenwiderstand-Referenzwert iRW zeitlich veränderlich. Die Vorrichtung 100 weist ferner ein Ausgabemodul 150 zum Ausgeben des Klassifizierungsergebnis KE auf. Bevorzug kann die Vorrichtung auch ein Diagnosemodul 160 aufweisen, welches beispielsweise das Klassifizierungsergebnis KE auswertet und basierend darauf ein Kontrollsignal KS generiert. Vorliegend wird von dem Diagnosemodul 160 neben dem Kontrollsignal KS bevorzugt auch das Klassifizierungsergebnis KE an die Ausgabevorrichtung 1800, welche beispielsweise ein Display ist, ausgegeben.

Die Vorrichtung 100 kann Teil des Batteriemanagementsystems oder eine eigenständige Recheneinheit sein, welche beispielsweise auf einem Server oder in dem Batteriepack 1001 integriert sein kann.

Die Figuren 3 und 4 zeigen ferner ein erfindungsgemäßes Batteriesystems 1000. Das Batteriesystem 1000 weist die vorgenannte Vorrichtung 100 sowie ein Batteriepack 1001 auf, welches eine Vielzahl der Batteriezellen 1100 aufweist. Die Batteriezellen 1100 sind mit ihren jeweiligen Batteriezellen-Elektroden 1102, 1103 in Reihe geschaltet dargestellt. Das Batteriepack 1001 weist ebenfalls Elektroden 1002, 1003 auf. Jede der Batteriezellen 1100 weist einen Spannungssensor 1101 zur Erfassung der Zellspannung V_Zell auf. Ferner ist wenigstens ein Stromsensor 1200 zur Erfassung des korrespondierenden Stroms I_Zell vorgesehen. In Figur 4 ist der Strom I_Zell mit dem Batteriepack-Strom identisch, so dass der Strom I_Zell nur für alle Batteriezellen 1100 einmal und nicht je Batteriezelle 1100 erfasst werden muss. Für die Ermittlung des Innenwiderstands iR kann der Batteriepack-Strom dann je Batteriezelle 1100 verwendet werden.

In Figur 4 ist ferner exemplarisch dargestellt, dass neben der Ausgabe des Klassifizierungsergebnis KE an die Ausgabevorrichtung 1800 auch eine Ausgabe eines Kontrollsignals KS an eine Abschaltvorrichtung 1500 erfolgen kann, um beispielsweise schadhafte Batteriezellen 1100 vor einem Kurzschluss zu bewahren oder diese in dem Batteriesystem 1100 zu deaktivieren, ehe es zu einem Thermal Runaway kommt. Die Abschaltvorrichtung 1500 kann hierzu einen Trennabschnitt 1501 aufweisen, der aufgrund einer Aktivierung über das Kontrollsignal KS eine elektrische Trennung der Batteriezellen- Elektroden 1102, 1103 im Inneren der Batteriezelle 1100 vornehmen kann.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 10: Verfahren
- S10: Kalibrier-Schritt
- S20: Erfassen-Schritt
- S30: Innenwiderstand-Ermittlungsschritt
- S301: Ermittlung für konstanten Betriebsmodus
- S302: Ermittlung für dynamischen Betriebsmodus
- S303: Ermittlung für Leerlauf-Betriebsmodus
- S31: Betriebsmodus-Ermittlungsschritt
- S40: Klassifizieren-Schritt
- S41: Referenzwert-Ermittlungsschritt
- S411: Initialer Referenzwert-Ermittlungsschritt
- S412: Laufender Referenzwert-Ermittlungsschritt
- S42: Abweichungs-Ermittlungsschritt
- S50: Ausgabe-Schritt
- S60: Diagnose- und/oder Analyse-Schritt
- S70: Kontroll-Schritt
- S80: Validieren-Schritt

- 100: Vorrichtung
- 120: Erfassungsmodul
- 130: Ermittlungsmodul
- 131: Betriebsmodus-Ermittlungsmodul
- 140: Klassifizierungsmodul
- 150: Ausgabemodul
- 160: Diagnosemodul

- 1000: Batteriesystem
- 1001: Batteriepack
- 1002, 1003: Batteriepack-Elektrode
- 1100: Batteriezelle
- 1101: Spannungssensor
- 1102, 1103: Batteriezellen-Elektrode
- 1200: Stromsensor
- 1500: Abschaltvorrichtung
- 1501: Trennabschnitt
- 1800: Ausgabevorrichtung

- KS: Kontrollsignal
- V_Zell: Zellenspannung
- I_Zell: Zellstrom, gegebenenfalls auch Batteriepack-Strom
- iR: Innenwiderstand
- iRW: Innenwiderstand-Referenzwert
- ΔiR: Abweichung
- IBM: Ist-Betriebsmodus
- KE: Klassifizierungsergebnis
- t_0: Strompuls-Beginn
- t_1: Strompuls-Ende
- VD: dynamischer Abschnitt des Verlaufs
- VK: konstanter Abschnitt des Verlaufs
- SP: Strompuls

## Patentansprüche

1. Verfahren (10) zur Klassifizierung von Batteriezellen (1100) eines Batteriepacks (1001) hinsichtlich ihrer Zellgesundheit, aufweisend die Schritte:
• Erfassen einer Zellenspannung (V_Zell) und eines dazu korrespondierenden elektrischen Stroms (I_Zell) für jede der zu klassifizierenden Batteriezellen (1100),
• Ermitteln des elektrischen Innenwiderstands (iR) der jeweiligen Batteriezelle (1100) zu der erfassten Zellenspannung (V_Zell) und dem erfassten Strom (I_Zell),
• Klassifizieren jeder der Batteriezellen (1100) auf Basis der ermittelten Innenwiderstände (iR) als gesund, wenn eine Abweichung ΔiR des jeweiligen Innenwiderstands (iR) von einem Innenwiderstand-Referenzwert (iRW) innerhalb eines Normalbereichs liegt, und
• Ausgeben der Klassifizierung der Batteriezellen (1100) als Klassifizierungsergebnis (KE), wobei der Innenwiderstand-Referenzwert (iRW) zeitlich veränderlich ist,
**gekennzeichnet durch,**
• Ermitteln eines Ist-Betriebsmodus (IBM) des Batteriepacks (1001) wenigstens aus einem Verlauf des für die Batteriezellen (1100) erfassten Stroms (I_Zell) und bevorzugt ferner aus einem Verlauf wenigstens einer erfassten Zellenspannung (V_Zell), wobei der Ist-Betriebsmodus (IBM) aufweist:
o einen Konstant-Betriebsmodus, insbesondere einen Batterie-Ladebetriebsmodus und/oder einen Batterie-Entladebetriebsmodus, für einen Abschnitt (VK) des Verlaufs des Stroms (I_Zell) mit einem konstanten oder im wesentlich konstanten Verlauf und bevorzugt keiner Nullstelle,
o einen Dynamik-Betriebsmodus, insbesondere einen Fahrbetriebsmodus, für einen Abschnitt (VD) des Verlaufs des Stroms (I_Zell) mit wenigstens einem Strompuls (SP) und bevorzugt mit wenigstens einer Nullstelle, und/oder
• einen Leerlauf-Betriebsmodus für einen Abschnitt des Verlaufs des Stroms (I_Zell) mit keinem oder nahezu keinem Stromfluss, und
• der Innenwiderstand (iR) der Batteriezellen (1100) in Abhängigkeit von dem ermittelten Ist-Betriebsmodus (IBM) des Batteriepacks (1001) ermittelt wird,
o wobei im Konstant-Betriebsmodus der Innenwiderstand (iR) aus einem Potentialunterschied zwischen einer Ist-Leerlaufspannung der Batteriezelle (1100) und der erfassten Zellenspannung (V_Zell), und aus dem erfassten Strom (I_Zell) ermittelt wird, wobei bevorzugt die Ist-Leerlaufspannung zu einem erfassten Ladezustand der Batteriezelle (1100) ermittelt wird, und/oder
o wobei im Dynamik-Betriebsmodus der Innenwiderstand (iR) aus einer Differenz der erfassten Zellenspannung (V_Zell) zu Beginn (t_0) und am Ende (t_1) eines Strompulses (SP), und aus dem am Ende eines Strompulses (SP) erfassten Strom (I_Zell) ermittelt wird.

2. Verfahren (10) gemäß Anspruch 1, **gekennzeichnet dadurch, dass** der Innenwiderstand-Referenzwert (iRW)
• von einem früheren, bevorzugt dem letzten, Klassifizierungsergebnis (KE) abhängt,
• ein Mittelwert aus den ermittelten Innenwiderständen (iR) von zuletzt als gesund klassifizierten Batteriezellen (1100) ist,
• für jede der Batteriezellen (1100) identisch oder unterschiedlich ist, und/oder
• initial ein Mittelwert aus den ermittelten Innenwiderständen (iR) jeder der Batteriezellen (1100) ist, oder initial ein bei der Batteriepackherstellung bestimmter Innenwiderstand ist, bevorzugt ein Mittelwert aus den bei der Batteriepackherstellung bestimmten Innenwiderständen (iR) der Batteriezellen (1100) ist.

3. Verfahren (10) gemäß Anspruch 1 oder Anspruch 2, **gekennzeichnet**
**dadurch, dass**
die Abweichung ΔiR eine bevorzugt prozentuale Abweichung des Innenwiderstands (iR) der jeweiligen Batteriezelle (1100) von dem Innenwiderstand-Referenzwert (iRW) in Relation zu dem Innenwiderstand-Referenzwert (iRW) ist, und bevorzugt die Abweichung ΔiR durch Division eines Differenzergebnisses, welches die Differenz aus dem Innenwiderstand (iR) der jeweiligen Batteriezelle (1100) und dem Innenwiderstand-Referenzwert (iRW) ist, durch den Innenwiderstand-Referenzwert (iRW) ermittelt wird.

4. Verfahren (10) gemäß einem der vorhergehenden Ansprüche,
**gekennzeichnet dadurch, dass**
für jede der Batteriezellen (1100) der Strom (I_Zell) an einer Elektrode (1002, 1003) des Batteriepacks (1001) oder an einer Elektrode (1102, 1103) der jeweiligen Batteriezelle (1100) erfasst wird.

5. Verfahren (10) gemäß einem der vorhergehenden Ansprüche,
**gekennzeichnet durch**
• Klassifizieren jeder der Batteriezellen (1100) auf Basis der ermittelten Innenwiderstände (iR) als anormal, wenn die Abweichung ΔiR außerhalb des Normalbereichs liegt, und bevorzugt ferner
o Klassifizieren jeder der als anormal klassifizierten Batteriezellen (1100) als stark-alternd, wenn die Abweichung ΔiR größer als eine Alterungsabweichungsgrenze ist,
o Klassifizieren jeder der als anormal klassifizierten Batteriezellen (1100) als Kurzschluß-gefährdet, wenn die Abweichung ΔiR negativ und kleiner als eine Kurzschlussabweichungsgrenze ist und bevorzugt die Abweichung ΔiR eine Änderungsrate größer als ein Änderungsratengrenzwert aufweist,
o Klassifizieren jeder der als anormal klassifizierten Batteriezellen (1100) als überhitzt, wenn die Abweichung ΔiR negativ und kleiner als eine Temperaturabweichungsgrenze ist und wenigstens eine erfasste Temperatur des Batteriepacks (1001) eine Temperaturgrenze passiert.

6. Verfahren (10) gemäß einem der vorhergehenden Ansprüche,
**gekennzeichnet dadurch, dass**
der Normalbereich eine Obergrenze und eine Untergrenze aufweist, welche bevorzugt in Abhängigkeit von der Baustruktur der Batteriezelle (1100) definiert sind,
wobei bevorzugt Werte aus dem Normalbereich absolut gesehen kleiner sind als die Alterungsabweichungsgrenze, die Kurzschlussabweichungsgrenze oder die Temperaturabweichungsgrenze.

7. Verfahren (10) gemäß einem der vorhergehenden Ansprüche,
**gekennzeichnet durch**
• Ausgeben, bevorzugt an eine Ausgabevorrichtung (1800) für einen Benutzer,
o von Informationen zu dem Klassifikationsergebnis, insbesondere zu der Anzahl und bevorzugt zu Identifikationsnummern der als gesund klassifizierten Batteriezellen (1100) und zu der Anzahl aller der Batteriezellen (1100),
o einer Warnung, und/oder
o eines Kontrollsignals (KS) zur Übermittlung an eine Steuervorrichtung des Batteriepacks (1001), um die Batteriezellen (1100) des Batteriepacks (1001) in Abhängigkeit von dem jeweiligen Klassifikationsergebnis wahlweise zu aktivieren oder deaktivieren.

8. Verfahren (10) gemäß einem der vorhergehenden Ansprüche,
**gekennzeichnet dadurch, dass**
• das Verfahren (10) zur Klassifizierung der Batteriezellen (1100) während des laufenden Betriebs des Batteriepacks (1001) vorgesehen ist,
• das Batteriepack (1001) einen Spannungssensor (1101) für jede der zu klassifizierenden Batteriezellen (1100) aufweist, um die jeweilige Zellenspannung (V_Zell) zu erfassen,
• das Batteriepack (1001) wenigstens 100 oder 200 Batteriezellen (1100) aufweist,
• das Batteriepack (1001) eine Lithium-Ionen Batteriepack ist,
• das Batteriepack (1001) ein Hochspannungsbatteriepack für ein Elektrofahrzeug ist, und/oder
• die Batteriezellen (1100) in dem Batteriepack (1001) in Reihe geschaltet sind.

9. Computerprogrammprodukt, umfassend Befehle, die bei der Ausführung des Programms durch einen Computer diesen veranlassen, ein Verfahren (10) gemäß einem der vorhergehenden Ansprüche auszuführen.

10. Vorrichtung (100) zur Klassifizierung von Batteriezellen (1100) eines Batteriepacks (1001) hinsichtlich ihrer Zellgesundheit, aufweisend
• ein Erfassungsmodul (120) zum Erfassen einer Zellenspannung (V_Zell) und eines dazu korrespondierenden elektrischen Stroms (I_Zell) für jede der zu klassifizierenden Batteriezellen (1100),
• ein Ermittlungsmodul (130) zum Ermitteln des elektrischen Innenwiderstands (iR) der jeweiligen Batteriezelle (1100) zu der erfassten Zellenspannung (V_Zell) und dem erfassten Strom (I_Zell),
• ein Klassifizierungsmodul (140) zum Klassifizieren jeder der Batteriezellen (1100) auf Basis der ermittelten Innenwiderstände (iR), wobei das Klassifizierungsmodul (140) dazu eingerichtet ist, die Batteriezellen (1100) als gesund zu klassifizieren, wenn eine Abweichung ΔiR des jeweiligen Innenwiderstands (iR) von einem Innenwiderstand-Referenzwert (iRW) innerhalb eines Normalbereichs liegt, wobei der Innenwiderstand-Referenzwert (iRW) zeitlich veränderlich ist, und
• ein Ausgabemodul (150) zum Ausgeben der Klassifizierung der Batteriezellen (1100) als Klassifizierungsergebnis (KE), **gekennzeichnet durch:**
• ein Betriebsmodus-Ermittlungsmodul (131) zum Ermitteln eines Ist-Betriebsmodus (IBM) des Batteriepacks (1001) wenigstens aus einem Verlauf des für die Batteriezellen (1100) erfassten Stroms (I_Zell) und bevorzugt ferner aus einem Verlauf wenigstens einer erfassten Zellenspannung (V_Zell), wobei der Ist-Betriebsmodus (IBM) aufweist:
o einen Konstant-Betriebsmodus, insbesondere einen Batterie-Ladebetriebsmodus und/oder einen Batterie-Entladebetriebsmodus, für einen Abschnitt (VK) des Verlaufs des Stroms (I_Zell) mit einem konstanten oder im wesentlich konstanten Verlauf und bevorzugt keiner Nullstelle,
o einen Dynamik-Betriebsmodus, insbesondere einen Fahrbetriebsmodus, für einen Abschnitt (VD) des Verlaufs des Stroms (I_Zell) mit wenigstens einem Strompuls (SP) und bevorzugt mit wenigstens einer Nullstelle, und/oder
o einen Leerlauf-Betriebsmodus für einen Abschnitt des Verlaufs des Stroms (I_Zell) mit keinem oder nahezu keinem Stromfluss, wobei
• das Betriebsmodus-Ermittlungsmodul (131) dazu eingerichtet ist, den Innenwiderstand (iR) der Batteriezellen (1100) in Abhängigkeit von dem ermittelten Ist-Betriebsmodus (IBM) des Batteriepacks (1001) zu ermitteln,
o wobei im Konstant-Betriebsmodus der Innenwiderstand (iR) aus einem Potentialunterschied zwischen einer Ist-Leerlaufspannung der Batteriezelle (1100) und der erfassten Zellenspannung (V_Zell), und aus dem erfassten Strom (I_Zell) ermittelt wird, wobei bevorzugt die Ist-Leerlaufspannung zu einem erfassten Ladezustand der Batteriezelle (1100) ermittelt wird, und/oder
o wobei im Dynamik-Betriebsmodus der Innenwiderstand (iR) aus einer Differenz der erfassten Zellenspannung (V_Zell) zu Beginn (t_0) und am Ende (t_1) eines Strompulses (SP), und aus dem am Ende eines Strompulses (SP) erfassten Strom (I_Zell) ermittelt wird.

11. Batteriesystem (1000), aufweisend:
• wenigstens ein Batteriepack (1001) mit einer Vielzahl von bevorzugt in Reihe geschalteter Batteriezellen (1100),
• Spannungssensoren (1101) zur Erfassung der Zellenspannung (V_Zell) jeder der zu klassifizierenden Batteriezellen (1100) und wenigstens einen Stromsensor (1200) zur Erfassung des Stroms (I_Zell),
**gekennzeichnet durch**
• eine Vorrichtung (100) zur Klassifizierung von Batteriezellen (1100) eines Batteriepacks (1001) hinsichtlich ihrer Zellgesundheit gemäß Anspruch 10.

12. Batteriesystem (1000) gemäß Anspruch 11, **gekennzeichnet durch**
• wenigstens eine Abschaltvorrichtung (1500) mit einem schaltbaren Trennabschnitt (1501) zur Unterbrechung des elektrischen Ladungstransports in einer der Batteriezellen (1100), wobei die Abschaltvorrichtung (1500) mit der Vorrichtung (100) verbunden ist, um die Abschaltvorrichtung (1500) in Abhängigkeit des Klassifizierungsergebnisses (KE) zu schalten, und/oder
• eine Ausgabevorrichtung (1800) für einen Benutzer zur Ausgabe des Klassifizierungsergebnisses (KE).

## Claims

1. Method (10) for classifying battery cells (1100) of a battery pack (1001) with regard to their cell health, comprising the steps of:
• capturing a cell voltage (V_Zell) and a corresponding electric current (I_Zell) for each of the battery cells (1100) to be classified,
• determining the electrical internal resistance (iR) of the respective battery cell (1100) at the captured cell voltage (V_Zell) and the captured current (I_Zell),
• classifying each of the battery cells (1100) on the basis of the determined internal resistances (iR) as healthy if a deviation AiR of the respective internal resistance (iR) from an internal resistance reference value (iRW) lies within a normal range, and
• outputting the classification of the battery cells (1100) as a classification result (KE), wherein
the internal resistance reference value (iRW) is variable over time,
**characterized by,**
• determining an actual operating mode (IBM) of the battery pack (1001) at least from a profile of the current (I_Zell) captured for the battery cells (1100) and preferably further from a profile of at least one captured cell voltage (V_Zell), wherein the actual operating mode (IBM) comprises:
o a constant operating mode, in particular a battery charging operating mode and/or a battery discharging operating mode, for a section (VK) of the profile of the current (I_Zell) having a constant or substantially constant profile and preferably no zero crossing,
o a dynamic operating mode, in particular a driving operating mode, for a section (VD) of the profile of the current (I_Zell) having at least one current pulse (SP) and preferably having at least one zero crossing, and/or
• an idle operating mode for a section of the profile of the current (I_Zell) having no or nearly no current flow, and
• the internal resistance (iR) of the battery cells (1100) is determined as a function of the determined actual operating mode (IBM) of the battery pack (1001),
o wherein, in the constant operating mode, the internal resistance (iR) is determined from a potential difference between an actual open-circuit voltage of the battery cell (1100) and the captured cell voltage (V_Zell), and from the captured current (I_Zell), wherein preferably the actual open-circuit voltage is determined at a captured state of charge of the battery cell (1100), and/or
o wherein, in the dynamic operating mode, the internal resistance (iR) is determined from a difference of the captured cell voltage (V_Zell) at the beginning (t₀) and at the end (t₁) of a current pulse (SP), and from the current (I_Zell) captured at the end of a current pulse (SP).

2. Method (10) according to claim 1, **characterized in that**
the internal resistance reference value (iRW)
• depends on a previous, preferably the last, classification result (KE),
• is an average value of the determined internal resistances (iR) of battery cells (1100) most recently classified as healthy,
• is identical or different for each of the battery cells (1100), and/or
• initially is an average value of the determined internal resistances (iR) of each of the battery cells (1100), or initially is an internal resistance determined during manufacture of the battery pack, preferably an average value of the internal resistances (iR) of the battery cells (1100) determined during manufacture of the battery pack.

3. Method (10) according to claim 1 or claim 2, **characterized in that**
the deviation ΔiR is preferably a percentage deviation of the internal resistance (iR) of the respective battery cell (1100) from the internal resistance reference value (iRW) relative to the internal resistance reference value (iRW), and preferably the deviation ΔiR is determined by dividing a difference result, which is the difference between the internal resistance (iR) of the respective battery cell (1100) and the internal resistance reference value (iRW), by the internal resistance reference value (iRW).

4. Method (10) according to any one of the preceding claims, **characterized in that**
for each of the battery cells (1100), the current (I_Zell) is captured at an electrode (1002, 1003) of the battery pack (1001) or at an electrode (1102, 1103) of the respective battery cell (1100).

5. Method (10) according to any one of the preceding claims, **characterized by**
• classifying each of the battery cells (1100) on the basis of the determined internal resistances (iR) as abnormal if the deviation ΔiR lies outside the normal range, and preferably further
o classifying each of the battery cells (1100) classified as abnormal as strongly ageing if the deviation ΔiR is greater than an ageing deviation threshold,
o classifying each of the battery cells (1100) classified as abnormal as at risk of short circuit if the deviation ΔiR is negative and less than a short-circuit deviation threshold and preferably the deviation ΔiR has a rate of change greater than a rate-of-change threshold,
o classifying each of the battery cells (1100) classified as abnormal as overheated if the deviation ΔiR is negative and less than a temperature deviation threshold and at least one captured temperature of the battery pack (1001) exceeds a temperature threshold.

6. Method (10) according to any one of the preceding claims, **characterized in that**
the normal range has an upper limit and a lower limit, which are preferably defined as a function of the structural design of the battery cell (1100),
wherein preferably values from the normal range are, in absolute terms, smaller than the ageing deviation threshold, the short-circuit deviation threshold or the temperature deviation threshold.

7. Method (10) according to any one of the preceding claims, **characterized by**
• outputting, preferably to an output device (1800) for a user,
o information relating to the classification result, in particular relating to the number and preferably to identification numbers of the battery cells (1100) classified as healthy and to the total number of the battery cells (1100),
o a warning, and/or
o a control signal (KS) for transmission to a control device of the battery pack (1001) in order to selectively activate or deactivate the battery cells (1100) of the battery pack (1001) as a function of the respective classification result.

8. Method (10) according to any one of the preceding claims, **characterized in that**
• the method (10) for classifying the battery cells (1100) is intended to be carried out during operation of the battery pack (1001),
• the battery pack (1001) comprises a voltage sensor (1101) for each of the battery cells (1100) to be classified in order to capture the respective cell voltage (V_Zell),
• the battery pack (1001) comprises at least 100 or 200 battery cells (1100),
• the battery pack (1001) is a lithium-ion battery pack,
• the battery pack (1001) is a high-voltage battery pack for an electric vehicle, and/or
• the battery cells (1100) are connected in series in the battery pack (1001).

9. Computer program product, comprising instructions which, when the program is executed by a computer, cause the computer to carry out a method (10) according to any one of the preceding claims.

10. Device (100) for classifying battery cells (1100) of a battery pack (1001) with regard to their cell health, comprising
• a detection module (120) for capturing a cell voltage (V_Zell) and a corresponding electric current (I_Zell) for each of the battery cells (1100) to be classified,
• a determination module (130) for determining the electrical internal resistance (iR) of the respective battery cell (1100) at the captured cell voltage (V_Zell) and the captured current (I_Zell),
• a classification module (140) for classifying each of the battery cells (1100) on the basis of the determined internal resistances (iR), and
• an output module (150) for outputting the classification of the battery cells (1100) as a classification result (KE), **characterized by**:
• an operating mode determination module (131) for determining an actual operating mode (IBM) of the battery pack (1001) at least from a profile of the current (I_Zell) captured for the battery cells (1100) and preferably further from a profile of at least one captured cell voltage (V_Zell), wherein the actual operating mode (IBM) comprises:
o a constant operating mode, in particular a battery charging operating mode and/or a battery discharging operating mode, for a section (VK) of the profile of the current (I_Zell) having a constant or substantially constant profile and preferably no zero crossing,
o a dynamic operating mode, in particular a driving operating mode, for a section (VD) of the profile of the current (I_Zell) having at least one current pulse (SP) and preferably having at least one zero crossing, and/or
o an idle operating mode for a section of the profile of the current (I_Zell) having no or nearly no current flow, wherein
• the classification module (140) is configured to classify the battery cells (1100) as healthy if a deviation ΔiR of the respective internal resistance (iR) from an internal resistance reference value (iRW) lies within a normal range, wherein the internal resistance reference value (iRW) is variable over time, wherein
• the operating mode determination module (131) is configured to determine the internal resistance (iR) of the battery cells (1100) as a function of the determined actual operating mode (IBM) of the battery pack (1001),
o wherein, in the constant operating mode, the internal resistance (iR) is determined from a potential difference between an actual open-circuit voltage of the battery cell (1100) and the captured cell voltage (V_Zell), and from the captured current (I_Zell), wherein preferably the actual open-circuit voltage is determined at a captured state of charge of the battery cell (1100), and/or
o wherein, in the dynamic operating mode, the internal resistance (iR) is determined from a difference of the captured cell voltage (V_Zell) at the beginning (t₀) and at the end (t₁) of a current pulse (SP), and from the current (I_Zell) captured at the end of a current pulse (SP).

11. Battery system (1000), comprising:
• at least one battery pack (1001) having a plurality of battery cells (1100), preferably connected in series,
• voltage sensors (1101) for capturing the cell voltage (V_Zell) of each of the battery cells (1100) to be classified and at least one current sensor (1200) for capturing the current (I_Zell),
**characterized by**
• a device (100) for classifying battery cells (1100) of a battery pack (1001) with regard to their cell health according to claim 10.

12. Battery system (1000) according to claim 11, **characterized by**
• at least one disconnect device (1500) having a switchable disconnection section (1501) for interrupting the electrical charge transport in one of the battery cells (1100), wherein the disconnect device (1500) is connected to the device (100) in order to switch the disconnect device (1500) as a function of the classification result (KE), and/or
• an output device (1800) for a user for outputting the classification result (KE).

## Revendications

1. Procédé (10) de classification de cellules de batterie (1100) d'un bloc-batterie (1001) en ce qui concerne leur état de santé, comprenant les étapes consistant à :
• acquérir une tension de cellule (V_Zell) et un courant électrique correspondant (I_Zell) pour chacune des cellules de batterie (1100) à classifier,
• déterminer la résistance interne électrique (iR) de la cellule de batterie correspondante (1100) à partir de la tension de cellule (V_Zell) acquise et du courant (I_Zell) acquis,
• classifier chacune des cellules de batterie (1100) sur la base des résistances internes (iR) déterminées comme étant saine lorsque un écart ΔiR de la résistance interne (iR) correspondante par rapport à une valeur de référence de résistance interne (iRW) se situe dans une plage normale, et
• fournir la classification des cellules de batterie (1100) comme résultat de classification (KE), dans lequel
la valeur de référence de résistance interne (iRW) est variable dans le temps,
**caractérisé par,**
• déterminer un mode de fonctionnement réel (IBM) du bloc-batterie (1001) au moins à partir de l'évolution du courant (I_Zell) acquis pour les cellules de batterie (1100) et de préférence également à partir de l'évolution d'au moins une tension de cellule (V_Zell) acquise, le mode de fonctionnement réel (IBM) comprenant :
o un mode de fonctionnement constant, en particulier un mode de charge de batterie et/ou un mode de décharge de batterie, pour une section (VK) de l'évolution du courant (I_Zell) présentant une évolution constante ou sensiblement constante et de préférence sans passage par zéro,
o un mode de fonctionnement dynamique, en particulier un mode de fonctionnement en conduite, pour une section (VD) de l'évolution du courant (I_Zell) présentant au moins une impulsion de courant (SP) et de préférence au moins un passage par zéro, et/ou
• un mode de fonctionnement au repos pour une section de l'évolution du courant (I_Zell) ne présentant aucun ou pratiquement aucun flux de courant, et
• la résistance interne (iR) des cellules de batterie (1100) est déterminée en fonction du mode de fonctionnement réel (IBM) déterminé du bloc-batterie (1001),
o dans lequel, dans le mode de fonctionnement constant, la résistance interne (iR) est déterminée à partir d'une différence de potentiel entre une tension à vide réelle de la cellule de batterie (1100) et la tension de cellule (V_Zell) acquise, ainsi que du courant (I_Zell) acquis, la tension à vide réelle étant de préférence déterminée à un état de charge acquis de la cellule de batterie (1100), et/ou
o dans lequel, dans le mode de fonctionnement dynamique, la résistance interne (iR) est déterminée à partir d'une différence de la tension de cellule (V_Zell) acquise au début (t₀) et à la fin (t₁) d'une impulsion de courant (SP), et à partir du courant (I_Zell) acquis à la fin d'une impulsion de courant (SP).

2. Procédé (10) selon la revendication 1, **caractérisé en ce que**
la valeur de référence de résistance interne (iRW)
• dépend d'un résultat de classification (KE) précédent, de préférence du dernier,
• est une valeur moyenne des résistances internes (iR) déterminées des cellules de batterie (1100) classifiées en dernier comme étant saines,
• est identique ou différente pour chacune des cellules de batterie (1100), et/ou
• est initialement une valeur moyenne des résistances internes (iR) déterminées pour chacune des cellules de batterie (1100), ou est initialement une résistance interne déterminée lors de la fabrication du bloc-batterie, de préférence une valeur moyenne des résistances internes (iR) des cellules de batterie (1100) déterminées lors de la fabrication du bloc-batterie.

3. Procédé (10) selon la revendication 1 ou la revendication 2, **caractérisé en ce que**
l'écart ΔiR est de préférence un écart en pourcentage de la résistance interne (iR) de la cellule de batterie correspondante (1100) par rapport à la valeur de référence de résistance interne (iRW) en relation avec la valeur de référence de résistance interne (iRW), et de préférence l'écart ΔiR est déterminé par division d'un résultat de différence, qui est la différence entre la résistance interne (iR) de la cellule de batterie correspondante (1100) et la valeur de référence de résistance interne (iRW), par la valeur de référence de résistance interne (iRW).

4. Procédé (10) selon l'une quelconque des revendications précédentes, **caractérisé en ce que**
pour chacune des cellules de batterie (1100), le courant (I_Zell) est acquis à une électrode (1002, 1003) du bloc-batterie (1001) ou à une électrode (1102, 1103) de la cellule de batterie correspondante (1100).

5. Procédé (10) selon l'une quelconque des revendications précédentes, **caractérisé par**
• classifier chacune des cellules de batterie (1100) sur la base des résistances internes (iR) déterminées comme étant anormale lorsque l'écart ΔiR se situe en dehors de la plage normale, et de préférence en outre
o classifier chacune des cellules de batterie (1100) classifiées comme anormales comme fortement vieillissante lorsque l'écart ΔiR est supérieur à un seuil d'écart de vieillissement,
o classifier chacune des cellules de batterie (1100) classifiées comme anormales comme présentant un risque de court-circuit lorsque l'écart ΔiR est négatif et inférieur à un seuil d'écart de court-circuit et de préférence que l'écart ΔiR présente un taux de variation supérieur à un seuil de taux de variation,
o classifier chacune des cellules de batterie (1100) classifiées comme anormales comme surchauffée lorsque l'écart ΔiR est négatif et inférieur à un seuil d'écart de température et qu'au moins une température acquise du bloc-batterie (1001) dépasse un seuil de température.

6. Procédé (10) selon l'une quelconque des revendications précédentes, **caractérisé en ce que**
la plage normale présente une limite supérieure et une limite inférieure, qui sont de préférence définies en fonction de la structure de conception de la cellule de batterie (1100),
les valeurs de la plage normale étant de préférence, en valeur absolue, inférieures au seuil d'écart de vieillissement, au seuil d'écart de court-circuit ou au seuil d'écart de température.

7. Procédé (10) selon l'une quelconque des revendications précédentes, **caractérisé par**
• délivrer, de préférence vers un dispositif de sortie (1800) pour un utilisateur,
o des informations relatives au résultat de classification, en particulier relatives au nombre et de préférence aux numéros d'identification des cellules de batterie (1100) classifiées comme saines et au nombre total des cellules de batterie (1100),
o un avertissement, et/ou
o un signal de commande (KS) destiné à être transmis à un dispositif de commande du bloc-batterie (1001) afin d'activer ou de désactiver sélectivement les cellules de batterie (1100) du bloc-batterie (1001) en fonction du résultat de classification correspondant.

8. Procédé (10) selon l'une quelconque des revendications précédentes, **caractérisé en ce que**
• le procédé (10) de classification des cellules de batterie (1100) est prévu pour être mis en œuvre pendant le fonctionnement du bloc-batterie (1001),
• le bloc-batterie (1001) comprend un capteur de tension (1101) pour chacune des cellules de batterie (1100) à classifier, afin d'acquérir la tension de cellule (V_Zell) correspondante,
• le bloc-batterie (1001) comprend au moins 100 ou 200 cellules de batterie (1100),
• le bloc-batterie (1001) est un bloc-batterie lithium-ion,
• le bloc-batterie (1001) est un bloc-batterie haute tension pour un véhicule électrique, et/ou
• les cellules de batterie (1100) sont connectées en série dans le bloc-batterie (1001).

9. Produit programme d'ordinateur, comprenant des instructions qui, lorsqu'elles sont exécutées par un ordinateur, amènent celui-ci à mettre en oeuvre un procédé (10) selon l'une quelconque des revendications précédentes.

10. Dispositif (100) de classification de cellules de batterie (1100) d'un bloc-batterie (1001) en ce qui concerne leur état de santé, comprenant
• un module de détection (120) pour acquérir une tension de cellule (V_Zell) et un courant électrique correspondant (I_Zell) pour chacune des cellules de batterie (1100) à classifier,
• un module de détermination (130) pour déterminer la résistance interne électrique (iR) de la cellule de batterie correspondante (1100) à partir de la tension de cellule (V_Zell) acquise et du courant (I_Zell) acquis,
• un module de classification (140) pour classifier chacune des cellules de batterie (1100) sur la base des résistances internes (iR) déterminées, et
• un module de sortie (150) pour délivrer la classification des cellules de batterie (1100) en tant que résultat de classification (KE), **caractérisé par :**
• un module de détermination du mode de fonctionnement (131) pour déterminer un mode de fonctionnement réel (IBM) du bloc-batterie (1001) au moins à partir de l'évolution du courant (I_Zell) acquis pour les cellules de batterie (1100) et de préférence également à partir de l'évolution d'au moins une tension de cellule (V_Zell) acquise, le mode de fonctionnement réel (IBM) comprenant :
o un mode de fonctionnement constant, en particulier un mode de charge de batterie et/ou un mode de décharge de batterie, pour une section (VK) de l'évolution du courant (I_Zell) présentant une évolution constante ou sensiblement constante et de préférence sans passage par zéro,
o un mode de fonctionnement dynamique, en particulier un mode de fonctionnement en conduite, pour une section (VD) de l'évolution du courant (I_Zell) présentant au moins une impulsion de courant (SP) et de préférence au moins un passage par zéro, et/ou
o un mode de fonctionnement au repos pour une section de l'évolution du courant (I_Zell) ne présentant aucun ou pratiquement aucun flux de courant, dans lequel
• le module de classification (140) est configuré pour classifier les cellules de batterie (1100) comme étant saines lorsque un écart ΔiR de la résistance interne (iR) correspondante par rapport à une valeur de référence de résistance interne (iRW) se situe dans une plage normale, la valeur de référence de résistance interne (iRW) étant variable dans le temps, dans lequel
• le module de détermination du mode de fonctionnement (131) est configuré pour déterminer la résistance interne (iR) des cellules de batterie (1100) en fonction du mode de fonctionnement réel (IBM) déterminé du bloc-batterie (1001),
o dans lequel, dans le mode de fonctionnement constant, la résistance interne (iR) est déterminée à partir d'une différence de potentiel entre une tension à vide réelle de la cellule de batterie (1100) et la tension de cellule (V_Zell) acquise, ainsi que du courant (I_Zell) acquis, la tension à vide réelle étant de préférence déterminée à un état de charge acquis de la cellule de batterie (1100), et/ou
o dans lequel, dans le mode de fonctionnement dynamique, la résistance interne (iR) est déterminée à partir d'une différence de la tension de cellule (V_Zell) acquise au début (t₀) et à la fin (t₁) d'une impulsion de courant (SP), et à partir du courant (I_Zell) acquis à la fin d'une impulsion de courant (SP).

11. Système de batterie (1000), comprenant :
• au moins un bloc-batterie (1001) comportant une pluralité de cellules de batterie (1100), de préférence connectées en série,
• des capteurs de tension (1101) pour acquérir la tension de cellule (V_Zell) de chacune des cellules de batterie (1100) à classifier et au moins un capteur de courant (1200) pour acquérir le courant (I_Zell),
**caractérisé par**
• un dispositif (100) de classification de cellules de batterie (1100) d'un bloc-batterie (1001) en ce qui concerne leur état de santé selon la revendication 10.

12. Système de batterie (1000) selon la revendication 11, **caractérisé par**
• au moins un dispositif de coupure (1500) comportant une section de coupure commutable (1501) pour interrompre le transport de charge électrique dans l'une des cellules de batterie (1100), le dispositif de coupure (1500) étant relié au dispositif (100) afin de commander le dispositif de coupure (1500) en fonction du résultat de classification (KE), et/ou
• un dispositif de sortie (1800) pour un utilisateur destiné à délivrer le résultat de classification (KE).
